# EUROPÄISCHE PATENTANMELDUNG

(11) **EP 2 768 292 A1**
(43) Veröffentlichungstag der Anmeldung: **20.08.2014**
(21) Anmeldenummer: 14000480.5
(22) Anmeldetag: 11.02.2014
(51) Int. Cl.: H05K 3/34, H01R 12/70, H05K 3/30

(54) **Verfahren zur beidseitigen Bestückung einer Leiterplatte**

(30) Priorität: 14.02.2013 DE 102013002597
(71) Anmelder: Rosenberger Hochfrequenztechnik GmbH & Co. KG, 83413 Fridolfing (DE)
(72) Erfinder: Maier, Johannes, Dipl.-Wirtsch.-Ing (FH), 83278 Traunstein (DE); Singhammer, Martin, Dipl.-Ing. (FH), 83413 Fridolfing (DE); Brixner, Matthias, 83413 Fridolfing (DE)
(74) Vertreter: Zeitler - Volpert - Kandlbinder

(57) **Zusammenfassung**

Ein Verfahren zur beidseitigen Bestückung einer Leiterplatte (1), bei dem
- die Leiterplatte (1) zunächst auf einer ersten, zu diesem Zeitpunkt oben liegenden Seite (2) mit (mindestens) einem ersten Bauteil (3) verlötet wird,
- die Leiterplatte (1) danach mitsamt des ersten Bauteils (3) umgedreht wird und
- die Leiterplatte (1) anschließend auf einer zweiten, dann oben liegenden Seite (4) mit (mindestens) einem zweiten Bauteil verlötet wird,

ist dadurch gekennzeichnet, dass das erste Bauteil (3) vor dem Verlöten des zweiten Bauteils durch (mindestens) ein Sicherungselement (5) gesichert wird.

## Beschreibung

Die Erfindung betrifft ein Verfahren zur beidseitigen Bestückung einer Leiterplatte sowie eine für die Durchführung dieses Verfahrens geeignete Leiterplatteneinheit.

Leiterplatten werden regelmäßig beidseitig mit elektrischen Bauteilen bestückt. Dies erfolgt in der Regel vollständig oder zumindest weitgehend automatisiert, wobei die Bauteile zur Befestigung an der Leiterplatte zumeist verlötet werden. Die Bestückung erfolgt regelmäßig so, dass zunächst eine erste, oben liegende Seite der Leiterplatte mit den Bauteilen bestückt wird. Dadurch wird vermieden, dass die Bauteile beim Verlöten gegen ein Herabfallen gesichert werden müssen. Nach einer ausreichenden Verfestigung des Lots wird die Leiterplatte dann umgedreht und die der ersten Seite gegenüberliegende zweite Seite entsprechend bestückt.

Damit kann das Problem einhergehen, dass durch die Wärmeeinbringung infolge des Verlötens der Bauteile der zweiten Seite das Lot der Bauteile der ersten Seite wieder (teilweise) aufgeschmolzen wird und sich die dann von der Leiterplatte herab hängenden Bauteile von der Leiterplatte lösen. Dieses Problem stellt sich in der Regel aber nur bei relativ schweren Bauteilen. Sind alle schweren Bauteile auf einer Seite der Leiterplatte vorgesehen, kann dieses Problem zudem dadurch umgangen werden, dass die Seite, für die die schweren Bauteile vorgesehen sind, als zweite Seite bestückt wird. Ansonsten besteht auch die Möglichkeit, die schweren Bauteile der ersten Seite individuell abzustützen und dadurch zu sichern, bis das Lot dieser Bauteile wieder verfestigt ist. Diese individuelle Abstützung schwerer Bauteile ist jedoch mit einem erheblichen Aufwand verbunden.

Ausgehend von diesem Stand der Technik lag der Erfindung die Aufgabe zugrunde, eine verbesserte Möglichkeit anzugeben, eine Leiterplatte auch beidseitig mit relativ schweren Bauteilen bestücken zu können.

Diese Aufgabe wird durch ein Verfahren gemäß dem unabhängigen Anspruch 1 gelöst. Eine zur Durchführung dieses Verfahrens geeignete Leiterplatteneinheit ist Gegenstand des unabhängigen Anspruchs 4. Vorteilhafte Ausgestaltungen des erfindungsgemäßen Verfahrens und der erfindungsgemäßen Leiterplatteneinheit sind Gegenstand der jeweiligen abhängigen Ansprüche und ergeben sich aus der nachfolgenden Beschreibung der Erfindung.

Der Erfindung liegt der Gedanke zugrunde, die Bestückung einer Leiterplatte auch beidseitig mit relativ schweren Bauteilen vornehmen zu können, wenn zumindest diejenigen schweren Bauteile, mit denen die erste Seite bestückt wird, durch zusätzliche Sicherungsmittel, die von der Wärmeeinbringung bei der Bestückung der zweiten Seite nicht in ihrer Sicherungswirkung betroffen sind, temporär oder dauerhaft zu sichern.

Dementsprechend ist erfindungsgemäß vorgesehen, ein gattungsgemäßes Verfahren zur beidseitigen Bestückung einer Leiterplatte, bei dem
- die Leiterplatte zunächst auf einer ersten, zu diesem Zeitpunkt oben liegenden Seite mit (mindestens) einem ersten Bauteil verlötet wird,
- die Leiterplatte danach mitsamt des ersten Bauteils umgedreht wird und
- die Leiterplatte anschließend auf einer zweiten, dann oben liegenden Seite mit (mindestens) einem zweiten Bauteil verlötet wird,
   dadurch weiterzubilden, dass das erste Bauteil vor dem Verlöten des zweiten Bauteils durch (mindestens) ein Sicherungselement gesichert wird.

Eine für die Durchführung des erfindungsgemäßen Verfahrens geeignete Leiterplatteneinheit umfasst zumindest eine Leiterplatte, (mindestens) ein mit einer ersten Seite der Leiterplatte verlötetes (erstes) Bauteil sowie (mindestens) ein die Leiterplatte mit dem (ersten) Bauteil mechanisch verbindendes Sicherungselement.

Das Sicherungselement wirkt vorzugsweise formschlüssig und ist besonders bevorzugt in Form einer Rastverbindung ausgebildet. Alternativ sind aber auch andere Wirkungsformen, insbesondere kraftschlüssig wirkende Sicherungselemente einsetzbar.

Beispielsweise kann vorgesehen sein, dass das erste Bauteil selbst das Sicherungselement ausgebildet. Dieses kann beispielsweise in Form einer Rastnase ausgebildet sein, die durch eine Durchgangsöffnung der Leiterplatte hindurch- und die Leiterplatte an der zweiten Seite hintergreift. Als nachteilig an dieser Ausgestaltung des Sicherungselements kann angesehen werden, dass die Rastnase die Leiterplatte an der zweiten Seite überragt und dadurch gegebenenfalls deren Bestückung erschwert.

Vorzugsweise kann daher vorgesehen sein, dass das Sicherungselement an der zweiten Seite der Leiterplatte in einer dort ausgebildeten Vertiefung abgestützt ist, wobei dieses besonders bevorzugt den Rand der Vertiefung nicht überragt.

Eine bevorzugte Ausführungsform des erfindungsgemäßen Verfahrens kann weiterhin vorsehen, dass das Sicherungselement durch eine Öffnung in der Leiterplatte von der zweiten Seite aus an dem ersten Bauteil befestigt wird, wobei hierzu ein Kopf des Sicherungselements an einem Abschnitt der zweiten Seite der Leiterplatte anliegen kann. Das Sicherungselement wäre somit kein integraler Bestandteil des ersten Bauteils. Dies kann den Vorteil haben, dass das Sicherungselement nur dann genutzt werden muss, wenn die Anordnung des Bauteils auf der ersten Seite der Leiterplatte dies sinnvoll macht. Wird das gleiche Bauteil dagegen zur Bestückung der zweiten Seite der Leiterplatte vorgesehen, kann das Befestigen des Sicherungselements ausbleiben. Dadurch kann gegebenenfalls der mit der Bestückung der zweiten Seite verbundene Aufwand reduziert werden oder es kann auf das Vorhalten von unterschiedlichen Bauteilen, die sich lediglich in der vorhandenen oder nicht vorhandenen Integration des Sicherungselements unterscheiden, verzichtet werden.

Weiterhin kann sich durch das Befestigen des Sicherungselements an dem ersten Bauteil von der zweiten Seite der Leiterplatte aus dessen Handhabung vereinfachen. Dies gilt insbesondere, wenn die Befestigung des Sicherungselements zu Beginn im Rahmen der Bestückung der zweiten Seite und somit erst nach dem Umdrehen der Leiterplatte vorgenommen wird, was ebenfalls automatisiert erfolgen kann.

Ein von der zweiten Seite aus an dem ersten Bauteil befestigtes Sicherungselement kann vorteilhafterweise in Form eines in eine Öffnung des Bauteils eingreifenden Sicherungsstifts ausgebildet sein, der weiterhin bevorzugt mit dem ersten Bauteil eine Rastverbindung ausbildet. Hierzu kann der Sicherungsstift einen umlaufenden Vorsprung aufweisen, der in eine Ausnehmung in der Wandung der Öffnung eingreift.

Die Befestigung des Sicherungsstifts an dem ersten Bauteil kann dadurch vereinfacht werden, dass dieser zumindest in demjenigen Bereich, mit dem dieser in die Öffnung eingreift (vorzugsweise jedoch über seiner gesamten Länge) einen kreisförmigen Querschnitt aufweist. Dadurch muss beim Befestigen des Sicherungsstifts auf keine vorgegebene Ausrichtung geachtet werden.

Die Erfindung wird nachfolgend anhand eines in den Zeichnungen dargestellten Ausführungsbeispiels näher erläutert. In den Zeichnungen zeigen die
- Fig. 1 bis Fig. 5:: verschiedene Schritte bei der Durchführung eines erfindungsgemäßen Verfahrens; und
- Fig. 6:: einen Vertikalschnitt durch eine erfindungsgemäße Leiterplatteneinheit in dem Zustand gemäß Fig. 5.

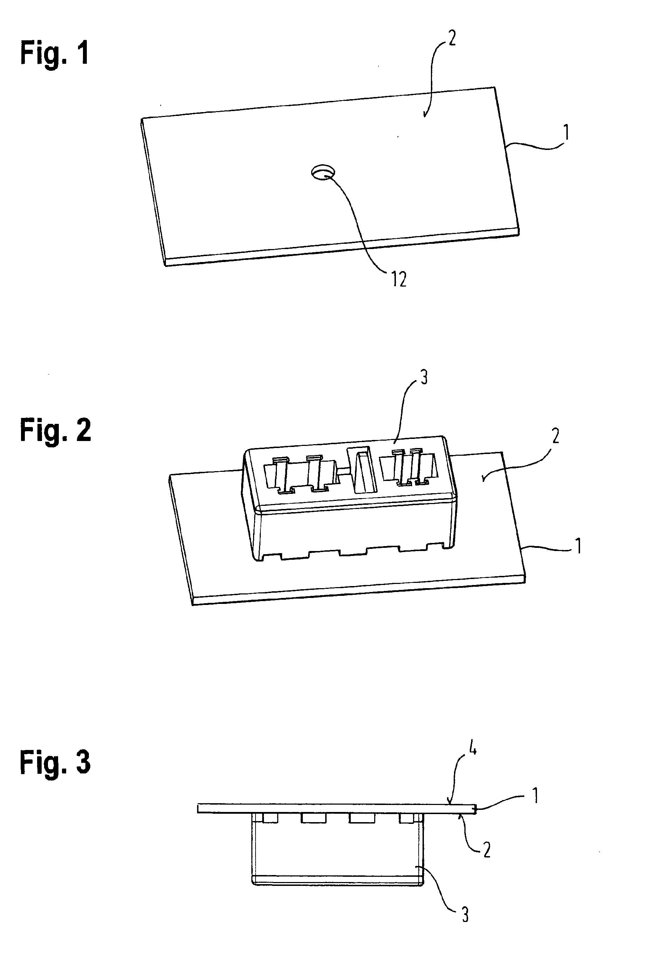

Die Fig. 1 bis 5 zeigen verschiedene Schritte bei der Durchführung eines erfindungsgemäßen Verfahrens.

Dabei zeigt die Fig. 1 eine Leiterplatte 1 mit einer Ansicht auf eine oben liegende erste Seite 2. Die Leiterplatte umfasst eine Trägerplatte aus einem elektrisch isolierenden Werkstoff, auf die Leiterbahnen (nicht dargestellt) aufgebracht sind.

Die Leiterplatte 1 wird auf ihrer ersten Seite 2 mit einem ersten elektrischen Bauteil, hier in Form eines Steckverbinders 3, bestückt (vgl. Fig. 2). Hierzu wird an der für den Steckverbinder 3 vorgesehenen Stelle zunächst eine Lötpaste auf die erste Seite 2 aufgebracht (z.B. durch Rakeln). Daraufhin wird der Steckverbinder 3 auf diese erste Seite 2 aufgesetzt und dann das in der Lötpaste enthaltene Lotmetallpulver durch Wärmezufuhr in bekannter Weise aufgeschmolzen. Nachdem Erstarren des Lotmetallpulvers ist der Steckverbinder 3 stoffschlüssig mit der ersten Seite 2 der Leiterplatte 1 verbunden.

Danach wird die Leiterplatte 1 mitsamt des Steckverbinders 3 umgedreht, so dass eine zweite Seite 4 oben liegt und sich der Steckverbinder 3 von der ersten Seite 2 aus nach unten, d.h. im Wesentlichen in Richtung der Schwerkraft erstreckt (vgl. Fig. 3). Dabei verhindert die Lötverbindung ein Herabfallen des Steckverbinders 3.

Vorgesehen ist, dass die Leiterplatte 1 auch auf der zweiten Seite 4 mit einem (zweiten) elektrischen Bauteil (nicht dargestellt) bestückt wird, wobei die Verbindung zwischen dem zweiten Bauteil und der Leiterplatte 1 ebenfalls durch Löten erfolgen soll. Die bei diesem Lötvorgang einzubringende Wärmeenergie birgt die Gefahr, dass die Lötverbindung des Steckverbinders 3 mit der ersten Seite 2 der Leiterplatte 1 wieder durch eine Verflüssigung des Lotmetallpulvers gelöst wird. Der hängende Steckverbinder 3 könnte dann herabfallen oder sich zumindest teilweise von der Leiterplatte lösen.

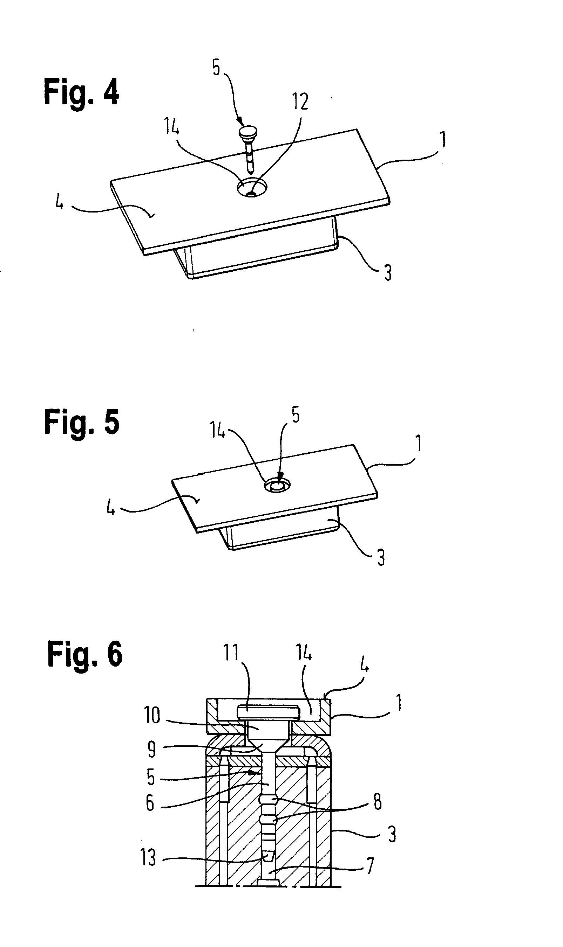

Um dies zu vermeiden ist erfindungsgemäß vorgesehen, den Steckverbinder 3 zusätzlich mittels eines Sicherungselements, dessen Sicherungswirkung nicht durch Wärmeeinbringung relevant beeinflusst wird, zu sichern. Dieses Sicherungselement ist in Form eines Sicherungsstifts 5 ausgebildet. Der Sicherungsstift 5 umfasst einen im Querschnitt kreisförmigen Schaft 6, der in eine im Querschnitt kreisförmige Öffnung 7 des Steckverbinders 3 eingesteckt wird. Dabei umfasst der Schaft 6 zwei umlaufende, abgerundete Vorsprünge 8, die in der vorgesehenen Endposition des Schafts 6 in komplementäre Ausnehmungen in der Wandung der Öffnung 7 eingreifen und somit eine Rastverbindung zwischen dem Sicherungsstift 5 und dem Steckverbinder 3 ausbilden (vgl. Fig. 6). Der Sicherungsstift 5 umfasst zudem einen abgestuft ausgebildeten Kopf. Über einen konischen Abschnitt 9 des Kopfs erweitert sich der Durchmesser des Sicherungsstifts 5 von dem Schaft 6 zu einem Zwischenabschnitt 10 des Kopfs. Von dem Zwischenabschnitt 10 geht der Kopf in einer Stufe in einen Endabschnitt 11 mit wiederum vergrößertem Querschnitt über.

Zur Sicherung des Steckverbinders 3 wird der Sicherungsstift 5 von der zweiten Seite 4 der Leiterplatte 1 aus durch eine Durchgangsöffnung 12 in der Leiterplatte 1 in die zu der Durchgangsöffnung 12 im Wesentlichen koaxial angeordnete Öffnung 7 des Steckverbinders 3 eingesteckt. Ein am steckseitigen Ende vorgesehener konischer Abschnitt 13 des Schafts 6 erleichtert dabei das Einführen in die Öffnung 7. Ebenso erleichtert der konische Abschnitt 9 des Kopfs das Einführen des Zwischenabschnitts 10 in die Durchgangsöffnung 12. Die Endposition wird durch ein Anschlagen des Endabschnitts 11 des Kopfs an der (zweiten Seite 4 der) Leiterplatte 1 sowie durch das Einrasten der umlaufenden Vorsprünge 8 in die Ausnehmungen in der Wandung der Öffnung 7 definiert.

Um ein Hervorstehen des Kopfs des Sicherungsstifts 5 zu vermeiden, ist dieser in einer Vertiefung 14 der Leiterplatte 1 angeordnet. Dieser behindert somit die Bestückung der zweiten Seite 4 der Leiterplatte 1 nicht.

## Patentansprüche

1. Verfahren zur beidseitigen Bestückung einer Leiterplatte (1), wobei die Leiterplatte (1)
- auf einer ersten, oben liegenden Seite (2) mit einem ersten Bauteil verlötet,
- dann zusammen mit dem ersten Bauteil umgedreht und
- schließlich auf einer zweiten, dann oben liegenden Seite (4) mit einem zweiten Bauteil verlötet wird,
**dadurch gekennzeichnet, dass** das erste Bauteil vor dem Verlöten des zweiten Bauteils durch ein Sicherungselement gesichert wird.

2. Verfahren gemäß Anspruch 1, **dadurch gekennzeichnet, dass** das Sicherungselement durch eine Durchgangsöffnung (12) in der Leiterplatte (1) von der zweiten Seite (4) aus an dem ersten Bauteil befestigt wird.

3. Verfahren gemäß Anspruch 2, **dadurch gekennzeichnet, dass** das Sicherungselement nach dem Umdrehen der Leiterplatte (1) an dem ersten Bauteil befestigt wird.

4. Leiterplatteneinheit mit einer Leiterplatte (1) und einem mit einer ersten Seite (2) der Leiterplatte (1) verlöteten Bauteil, **gekennzeichnet durch** ein die Leiterplatte (1) mit dem Bauteil verbindendes Sicherungselement.

5. Leiterplatteneinheit gemäß Anspruch 4, **dadurch gekennzeichnet, dass** das Sicherungselement an der zweiten Seite der Leiterplatte in einer dort ausgebildeten Vertiefung (14) abgestützt ist

6. Leiterplatteneinheit gemäß Anspruch 5, **dadurch gekennzeichnet, dass** das Sicherungselement den Rand der Vertiefung (14) nicht überragt.

7. Leiterplatteneinheit gemäß einem der Ansprüche 4 bis 6, **dadurch gekennzeichnet, dass** das Sicherungselement in Form eines in eine Öffnung (7) des Bauteils eingreifenden Sicherungsstifts (5) ausgebildet ist.

8. Leiterplatteneinheit gemäß Anspruch 6, **dadurch gekennzeichnet, dass** der Sicherungsstift (5) zumindest in demjenigen Bereich, mit dem dieser in die Öffnung (7) eingreift, einen kreisförmigen Querschnitt aufweist.
